# EUROPÄISCHE PATENTSCHRIFT

(11) **EP 1 248 398 B1**
(45) Veröffentlichungstag und Bekanntmachung des Hinweises auf die Patenterteilung: **11.06.2008**
(21) Anmeldenummer: 02007638.6
(22) Anmeldetag: 04.04.2002
(51) Int. Cl.: H04H 1/00, H03J 1/00

(54) **RDS-Rundfunkempfänger mit PTY-Auswahl**
RDS broadcast receiver with PTY selection
Récepteur pour radiodiffusion RDS à sélection PTY

(30) Priorität: 04.04.2001 DE 10116704
(43) Veröffentlichungstag der Anmeldung: 09.10.2002
(73) Patentinhaber: Continental Automotive GmbH, 30165 Hannover (DE)
(72) Erfinder: Geurts, Joris Hubertt Joseph, 5653 Eindhoven (NL); de Jong, Frits, 5672 VD Nuenen (NL)

(56) Entgegenhaltungen:
- EP-A- 0 680 165
- PATENT ABSTRACTS OF JAPAN vol. 1999, no. 04, 30. April 1999 (1999-04-30) & JP 11 004143 A (KENWOOD CORP), 6. Januar 1999 (1999-01-06)

## Beschreibung

Die Erfindung betrifft einen RDS-Rundfunkempfänger mit einer Bedieneinheit und einer optischen Ausgabeeinheit, die mit einer Steuereinheit verbunden sind, sowie mit Mitteln zum Dekodieren von RDS-Daten, die einen standardisierten Programmtypcode enthalten und der Steuereinheit zugeführt werden.

Entsprechende Rundfunkempfänger sind bekannt und werden kommerziell angeboten. Durch die Einführung des Radio-Data-Systems (RDS) konnte die Funktionalität von Rundfunkempfängern und hierbei insbesondere von Autoradios deutlich erhöht werden. Bei RDS handelt es sich um ein standardisiertes Verfahren zur Übertragung von Daten von den Rundfunkanstalten zu einem Rundfunkempfänger. Zu den übertragenen Daten gehören beispielsweise Angaben über alternative Frequenzen (AF), die Namen der Rundfunkanstalt (PS), die Kennzeichnung einer Verkehrsdurchsage (TA) und den Programmtyp (PTY). Der RDS-Standard ist in der internationalen Norm IEC 62106 festgeschrieben.

Innerhalb des RDS-Systems wird durch den Programmtypcode PTY eine Charakterisierung des Rundfunkprogramms von den Rundfunkanstalten zu dem Rundfunkempfänger übertragen. Hierzu sind in Annex F der oben genannten RDS-Norm insgesamt 31 Programmtypen vordefiniert. Die Kennzeichnung eines Rundfunkprogramms wird hierbei von dem Programmanbieter, also der Rundfunkanstalt, vorgenommen.

Aus der DE 42 33 282 A1 ist ein Rundfunkempfänger bekannt, bei dem der mit den RDS-Daten übertragene PTY-Code genutzt wird. Zur Auswahl eines bestimmten Programmtyps muß der Benutzer am Rundfunkempfänger ein Bedienelement betätigen, mit dem dieser auf den gewünschten Programmtyp eingestellt wird.

In vielen Fällen ist die Zuordnung eines Rundfunkprogramms zu einem der vordefinierten Programmtypen jedoch schwierig bzw. nicht eindeutig möglich. Dies kann beispielsweise die Zuordnung eines Musikprogramms zu den Programmtypen "light classics" oder "serious classics" oder auch die Zuordnung eines Informationsbeitrages zu den Programmtypen "Information", "culture" oder "leisure" betreffen. Darüber hinaus können die Erwartungen eines Rundfunkhörers an die mit einem der vordefinierten Programmtypen verknüpften Programminhalte auch von den Eingruppierungen seitens der Rundfunkanstalten abweichen. Wählt der Rundfunkhörer daher einen bestimmten Programmtyp PTY am Rundfunkempfänger aus, so werden hierdurch u.U. Rundfunksendungen ausgeschlossen, die eigentlich seinem Interessensgebiet entsprechen.

Aus der EP 0 680 165 A1 ist ein Verfahren bekannt, bei dem mehrere Programmtypcodes einem Bedienelement eines Rundfunkempfängers zugeordnet werden und nach Betätigen dieses Bedienelements Rundfundsender ausgewählt werden, die ein Programm mit einem der Programmtypcodes ausstrahlen. Das Verfahren ist jedoch unkomfortabel. Zudem muß der Benutzer wissen, welche Programmtypcodes dem einzelnen Bedienelement zugeordnet sind. Weiterhin ist nachteilig, dass für jede Gruppe ein Bedienelement vorhanden sein muß.

Hier setzt nun die vorliegende Erfindung ein, der die Aufgabe zugrunde liegt, einen RDS-Rundfunkempfänger derart weiterzubilden, dass eine verbesserte und komfortable Auswahl von programmtypbezogenen Rundfunksendern ermöglicht wird.

Die Aufgabe wird durch einen RDS-Rundfunkempfänger nach Anspruch 1 gelöst.

Bei dem erfindungsgemäßen Rundfunkempfänger besteht die Möglichkeit, mehrere Programmtypcodes auszuwählen. Ist der Hörer beispielsweise an bestimmten klassischen Musikstücken, wie z. B. Mozarts "Kleiner Nachtmusik", interessiert, so muß er sich bei einem herkömmlichen Rundfunkempfänger entweder für den Programmtyp "light classics" oder "serious classics" entscheiden, ohne jedoch zu wissen, in welche dieser beiden Kategorien seine gewünschte Musik von dem Programmanbieter eingeordnet wird. Bei dem erfindungsgemäßen Rundfunkempfänger kann der Hörer in diesem Falle aber sowohl den Programmtyp "light classics" als auch den Programmtyp "serious classics" wählen. Dem Hörer werden hierdurch von dem RDS-Rundfunkempfänger Rundfunkprogramme dieser beiden Programmtypen zur Auswahl angeboten.

Der Rundfunkempfänger enthält weiterhin Mittel zum Zusammenfassen von mehreren ausgewählten Programmtypcodes zu einer Programmtypgruppe. Dies hat den Vorteil, dass der Hörer eine individuelle Zusammenfassung von Programmtypcodes zu einer Programmtypgruppe vornehmen kann, die seinen bevorzugten Programminhalten entspricht. Das Zusammenfassen von mehreren ausgewählten Programmtypcodes zu einer Programmtypgruppe hat dabei insbesondere den Vorteil, dass der Hörer auch nach zwischenzeitlichem Wechsel zu einem anderen Programmtyp, beispielsweise "Sport", wieder zu der ursprünglichen Programmtypgruppe zurückkehren kann.

Weiterhin ist die Zuordnung einzelner Programmtypcodes zu einer Programmtypgruppe auch löschbar. Hierdurch wird eine Komfortable Editiermöglichkeit geschaffen, so dass die Zusammenstellung einer Programmtypgruppe jederzeit komfortabel an veränderte Bedürfnisse anpaßbar ist, ohne die gesamte Programmtypgruppe löschen zu müssen und anschließend vollständig neu eingeben zu müssen.

Eine Programmtypgruppe kann insbesondere auf der optischen Ausgabeeinheit darstellbar und über die Eingabeeinheit auswählbar sein. Dies bedeutet, dass die individuell zusammengestellte Programmtypgruppe ebenso wie ein vordefinierter Programmtyp nach dem RDS-Standard unmittelbar ausgewählt werden kann.

Um eine einmal ausgewählte Programmtypgruppe auch nach dem Aus- und erneutem Einschalten des Rundfunkempfängers wieder zur Verfügung zu haben, ist in einer besonderen Ausführungsform vorgesehen, dass die Programmtypgruppe in einem nicht-flüchtigen Speicherelement abspeicherbar ist. Die Programmtypgruppe steht daher auch nach einer Unterbrechung der Stromversorgung wieder zur Verfügung. Diese Ausgestaltung hat den Vorteil, dass ein Hörer einmal, z. B. bei Erwerb eines neuen Rundfunkempfängers, seine individuellen Programmtypgruppen festlegt und später jederzeit auf diese zurückgreifen kann. Für den Benutzer besteht dann kein Unterschied mehr zwischen der Auswahl einer Programmtypgruppe und einem vordefinierten Programmtyp nach dem RDS-Standard.

In einer weiteren Ausgestaltung der Erfindung ist vorgesehen, dass mehrere Programmtypgruppen abspeicherbar sind. Somit ist es möglich, dass der Nutzer des Rundfunksystems für verschiedene Gelegenheiten unterschiedliche individuelle Programmtypgruppen abspeichert. Hierbei kann es sich beispielsweise um eine Programmtypgruppe mit mehr informationsbezogenen Programmtypen für die morgendliche Fahrt zur Arbeit und eine mehr unterhaltungsbezogene Programmtypgruppe für das Wochenende handeln.

In einer weiteren Ausgestaltung der Erfindung ist vorgesehen, dass der Programmtypgruppe über die Bedieneinheit eine Kennzeichnung zuweisbar ist. Diese Ausgestaltung hat den Vorteil, dass der Nutzer der Programmtypgruppe einen Namen als Kennzeichnung zuordnen kann, anhand dessen er den Inhalt dieser Programmtypgruppe einfach identifizieren kann. Beispielsweise kann der Benutzer einer Programmtypgruppe mit den Programmtypen "light classics" und "serious classics" den Gruppennamen "Klassik" als Kennzeichnung zuweisen.

Die Zuweisung eines Namens ist besonders einfach möglich, wenn die Bedieneinheit des Rundfunkempfängers einen Dreh-/Drücksteller zur Eingabe der Kennzeichnung der Programmtypgruppe enthält. Mit einem solchen Dreh-/Drücksteller läßt sich insbesondere durch Drehen ein Cursor über eine auf der optischen Ausgabeeinheit angezeigte Buchstabenabfolge bewegen. Durch Drücken des Dreh-/Drückstellers ist ein angewählter Buchstabe zur Erzeugung des Namens für die Programmtypgruppe auswählbar. Somit läßt sich mit nur einem Bedienelement auch bei einem Autoradio eine komfortable Buchstabeneingabe realisieren. Durch die freie Wahl eines Namens für die Programmtypgruppe kann der Benutzer einen Namen wählen, der den Inhalt der Programmtypgruppe für ihn persönlich am einprägsamsten wiedergibt. Durch den Dreh-/Drücksteller kann auch die Auswahl einer Programmtypgruppe mit nur einem Bedienelement erfolgen, wobei durch Drehen einer Programmtypgruppe angewählt und durch Drücken ausgewählt wird.

Insbesondere bei Ausbildung des RDS-Rundfunkempfängers als Autoradio ist auf eine einfache Bedienung des Rundfunkempfängers besonderer Wert zu legen, um den Fahrer nicht unnötig abzulenken. In einer weiteren Ausführungsform der Erfindung ist daher vorgesehen, dass die Bedieneinheit Spracheingabemittel aufweist. Diese Ausgestaltung hat den Vorteil, dass der Fahrer beispielsweise eine Programmtypgruppe über einen Sprachbefehl auswählen kann, ohne den Blick auf den Rundfunkempfänger richten zu müssen.

In einer weiteren Ausführungsform ist vorgesehen, dass die optische Ausgabeeinheit als berührungsempfindliche Anzeigeeinheit ausgebildet ist, in die die Bedieneinheit zumindest teilweise integriert ist. Auch diese Ausgestaltung hat den Vorteil einer einfachen Bedienbarkeit des Rundfunkempfängers, insbesondere im Kraftfahrzeug.

Bei einem Verfahren zur Festlegung eines Rundfunksenders für Audiowiedergabe anhand eines RDS-Programmtypcodes mittels eines RDS-Rundfunkempfängers werden erfindungsgemäß mehrere standardisierte Programmtypcodes durch Auswahl aus mehreren auf einer optischen Ausgabeeinheit angezeigten Programmtypcodes zu einer Programmtypgruppe zusammengefaßt, und es wird ein Rundfunksender ausgewählt, dessen RDS-Programmtypcode in der Programmtypgruppe enthalten ist.

Die Erfindung wird nachfolgend anhand eines Ausführungsbeispiels und der Zeichnung näher erläutert. Es zeigen:
- Figur 1: die für die Erfindung wesentlichen Teile eines RDS-Rundfunkempfängers,
- Figur 2: einen Verfahrensablauf für eine Gruppenbildung,
- Figur 3: eine Bildschirmdarstellung,
- Figur 4: Beispiele von Programmtypgruppen,
- Figur 5: ein Verfahren zur Einstellung eines Rundfunksenders.

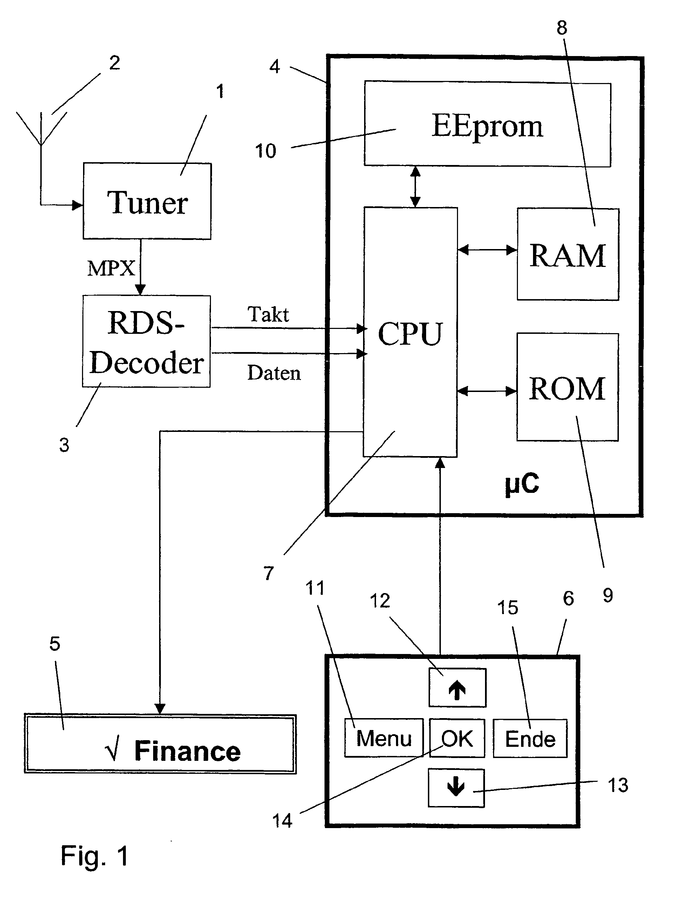

Figur 1 zeigt ein vereinfachtes Blockschaltbild der Teile eines Rundfunkempfängers, die im Zusammenhang mit der Erfindung von besonderer Bedeutung sind. Der Tuner 1 des Rundfunkempfängers erhält sein Eingangssignal von einer Antenne 2. Anstelle einer Einzelantenne können alternativ auch mehrere Antennen, insbesondere innerhalb eines sogenannten "antenna diversity"-Verfahrens vorhanden sein. Der Tuner 1 generiert ein Multiplex-Signal MPX. Das MPX-Signal des Tuners 1 wird einem RDS-Decoder 3 zugeführt. Der hier als RDS-Decoder 3 bezeichnete Baustein kann insbesondere ein bekannter Vorprozessor, beispielsweise des Typs SAA 6588, sein, der weitere Aufgaben übernimmt. Die Ausgangssignale des RDS-Decoders 3 werden einer zentralen Steuereinheit 4 zugeführt, die ihrerseits mit einer optischen Ausgabeeinheit (Display) 5 sowie einer Bedieneinheit 6 verbunden ist. Die Steuereinheit 4 enthält eine CPU 7, einen Arbeitsspeicher (RAM) 8, einen Nur-Lese-Speicher (ROM) 9 sowie ein nicht-flüchtiges Speicherelement 10, beispielsweise in Form eines sogenannten "EEPROM". Die Bedieneinheit 6 weist unterschiedliche Tasten 11 bis 15 auf, über die eine Steuerung des Systems seitens des Benutzers vorgenommen werden kann.

Die Bedienung kann zudem über eine mit dem Rundfunkempfänger über eine Funk- (insbesondere "Bluetooth"-) oder Infrarotverbindung verbundene Bedieneinheit, beispielsweise eine Fernbedienung, einen PC oder einen PDA, erfolgen.

Darüber hinaus enthält ein Rundfunkempfänger weitere, hier nicht dargestellte Komponenten, die für die Audiowiedergabe genutzt werden, wie insbesondere einen Sound-Prozessor, einen Verstärker und Lautsprecher. Entsprechende Rundfunkempfängerkomponenten sind bekannt und müssen daher nicht näher erläutert werden.

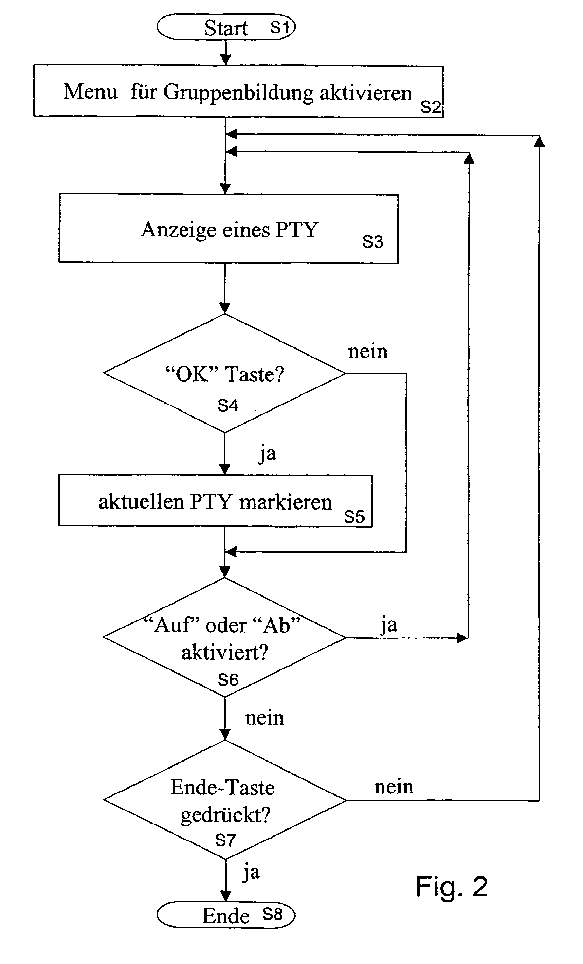

Figur 2 zeigt einen Verfahrensablauf zur Bildung einer Gruppe aus mehreren Programmtypcodes. Das Verfahren startet mit üblichen Initialisierungsschritten in Schritt S1. Anschließend wird in Schritt S2 ein Menü für die Gruppenbildung aktiviert. Dies kann beispielsweise durch Drücken der entsprechenden Taste 11 der Bedieneinheit 6 erfolgen. In Schritt S3 wird auf der optischen Anzeigeeinheit 5 zumindest einer der vordefinierten Programmtypen nach RDS-Norm angezeigt. Die Ausgestaltung der Anzeige ist hierbei auch von dem eingesetzten Display abhängig. Bei einem großformatigen Display können insbesondere auch mehrere Programmtypen gleichzeitig in Form einer Liste angezeigt werden. In diesem Fall ist einer der angezeigten Programmtypen der für die Auswahl aktuelle Programmtyp, der auf dem Display entsprechend kenntlich gemacht ist, beispielsweise durch einen Rahmen oder eine anderweitige optische Hervorhebung.

In Schritt S4 wird geprüft, ob vom Benutzer der aktuelle Programmtyp der Anzeige ausgewählt wurde, beispielsweise durch Drücken der "OK"-Taste 14. Ist dies der Fall, wird anschließend in Schritt S5 der aktuelle Programmtyp entsprechend markiert, wenn er zuvor nicht markiert war. Durch Drücken der "OK"-Taste 14 kann auch eine Markierung des aktuellen Programmtyps aufgehoben werden, wenn dieser zuvor markiert war.

Wurde in Schritt S4 dagegen festgestellt, dass die "OK"-Taste auch nach einer angemessenen Zeit nicht betätigt wurde, so wird anschließend in Schritt S6 geprüft, ob eine der Steuertasten 12, 13 zum Bewegen des Auswahlfeldes innerhalb der Programmtypliste aktiviert wurde. Ist dies der Fall, so wird das Programm mit Schritt S3 fortgesetzt. Über diese Schleife können somit mehrere Programmtypen markiert werden. In Schritt S7 wird schließlich geprüft, ob die "Ende"-Taste 15 gedrückt wurde, mit der das Programm zur Gruppenbildung verlassen wird. Ist dies nicht der Fall, so wird das Programm mit Schritt S3 fortgesetzt, andernfalls in Schritt S8 beendet. Mit dem beschriebenen Verfahren können somit mehrere Programmtypen innerhalb der Programmtypliste markiert werden, so dass die markierten Programmtypen eine Gruppe bilden.

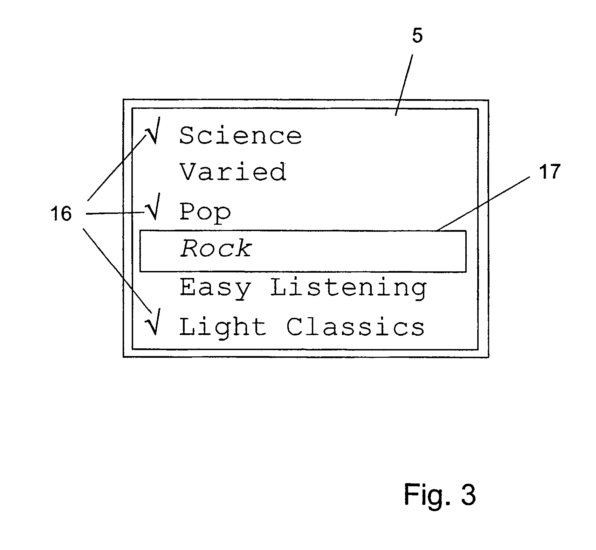

Figur 3 zeigt eine Bildschirmdarstellung mit einer Anzeige von sechs Programmtypen aus der Liste der vordefinierten Programmtypen gemäß RDS-Norm. Mittels Haken 16 sind dabei die Programmtypen "Science", "Pop" und "Light classics" markiert. Dies sind die Programmtypen, die von dem Benutzer ausgewählt wurden und daher eine Programmtypgruppe bilden. Der Programmtyp "Rock" ist in der Darstellung gemäß Figur 3 mit einem Rahmen versehen, um anzudeuten, dass es sich hierbei um den aktuell auswählbaren Programmtyp innerhalb des Verfahrens gemäß Figur 2 zur Bildung einer Gruppe handelt.

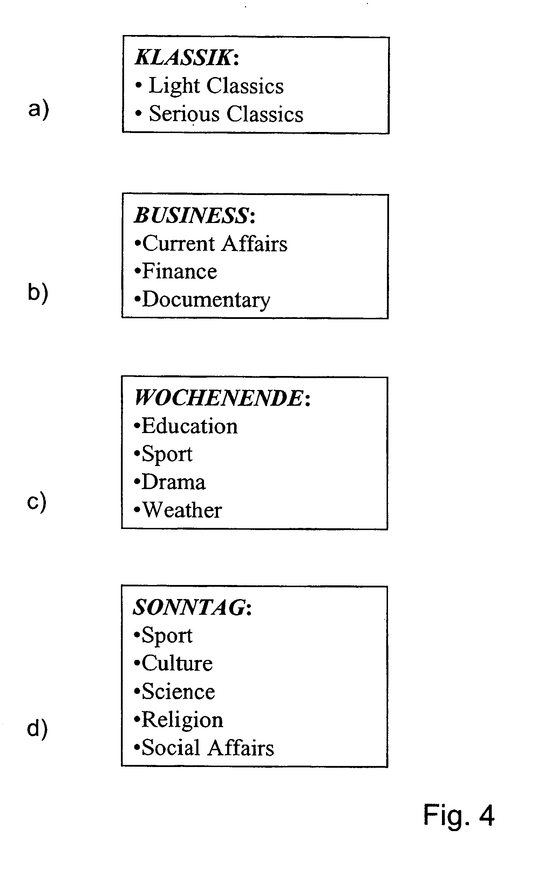

In Figur 4 sind beispielhaft verschiedene Programmtypgruppen dargestellt, die von einem Nutzer entsprechend ausgewählt wurden. Gemäß Figur 4a wurden vom Benutzer die vordefinierten Programmtypen "light classics" und "serious classics" zu einer Gruppe zusammengefügt. Dies kann beispielsweise mit dem in Figur 2 dargestellten Verfahrensablauf erfolgen. Zusätzlich wurde dieser Programmtypgruppe vom Benutzer ein neuer Name zugeordnet, und zwar die Bezeichnung "Klassik". Die Zuordnung einer solchen Kennzeichnung kann innerhalb eines weiteren Menüpunktes mittels eines entsprechenden Programmes erfolgen, wobei der Name vom Benutzer einzugeben ist. Die Eingabe des Namens kann über entsprechende Bedienelemente am Rundfunkempfänger erfolgen, wobei hier insbesondere eine Namenseingabe mit Buchstabenauswahl durch einen Dreh-Drück-Steller bevorzugt wird, wie sie bei Navigationsgeräten zur Eingabe eines Zielortes dem Fachmann bekannt ist.

Im Beispiel nach Figur 4b wurden drei weitere Programmtypen zu einer Programmtypgruppe namens "Business" zusammengefaßt. Die Figuren 4c und 4d zeigen weitere Beispiele von Programmtypgruppen, in denen unter den Bezeichnungen "Wochenende" bzw. "Sonntag" vier bzw. fünf vordefinierte RDS-Programmtypen zu Gruppen zusammengefaßt sind. Diese Programmtypgruppen können nun in dem nicht-flüchtigen Speicherelement 10 des Rundfunkempfängers abgespeichert werden, um zu einem späteren Zeitpunkt zur Verfügung zu stehen.

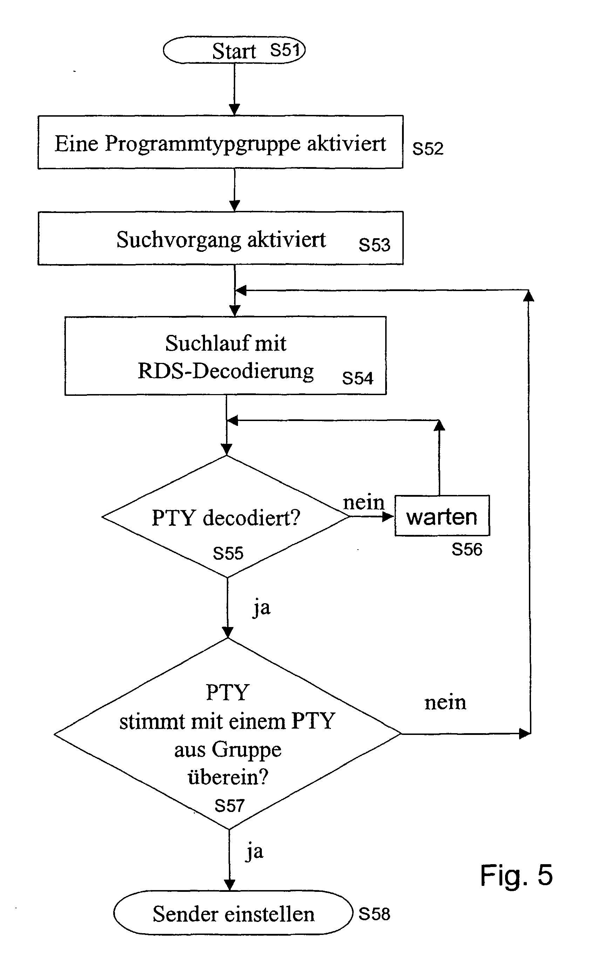

Figur 5 zeigt einen Verfahrensablauf zur Auswahl eines Rundfunksenders bei aktivierter Programmtypgruppe. Die abgespeicherten Programmtypgruppen können dem Benutzer insbesondere zusammen mit den vordefinierten Programmtypen gemäß RDS-Norm zur Auswahl angezeigt werden. In Schritt S52 wird nach Start eines entsprechenden Verfahrens in Schritt S51 eine Programmtypgruppe über die Bedieneinheit aktiviert. In Schritt S53 wird da-raufhin ein Suchvorgang im Rundfunkempfänger aktiviert. Als Folge hiervon wird in Schritt S54 ein Suchlauf über das gesamte Frequenzband mit Dekodierung der empfangenen RDS-Daten durchgeführt. In Schritt S55 wird geprüft, ob ein Programmtypcode PTY in den RDS-Daten dekodiert wurde. Ist dies nicht der Fall, so wird mit Schritt S56 eine Warteschleife durchlaufen. Wird in Schritt S55 dagegen ein Programmtypcode PTY dekodiert, so wird in Schritt S57 anschließend geprüft, ob der detektierte Programmtypcode mit einem der zur ausgewählten Programmtypgruppe gehörenden Programmtypcodes übereinstimmt. Ist dies nicht der Fall, so wird der Suchlauf in Schritt S54 fortgesetzt. Wird dagegen in Schritt S57 ein Programmtypcode PTY detektiert, der auch in der aktivierten Gruppe vorhanden ist, so wird in Schritt S58 der gefundene Sender eingestellt und über die Lautsprecher ausgegeben.

Mit der Erfindung wird ein RDS-Rundfunkempfänger zur Verfügung gestellt, der dem Benutzer eine größere Freiheit beim Einsatz von RDS-Programm-typcodes erlaubt, als dies bei bekannten Rundfunkempfängern der Fall ist, bei denen nur jeweils eine der in der RDS-Norm vordefinierten Programmtypcodes auswählbar ist.

## Patentansprüche

1. RDS-Rundfunkempfänger mit einer Bedieneinheit (6) und einer optischen Ausgabeeinheit (5), die mit einer Steuereinheit (4) verbunden sind, sowie mit Mitteln zum Dekodieren von RDS-Daten (RDS-Decoder 3), die einen standardisierten Programmtypcode enthalten und der Steuereinheit (4) zugeführt werden, wobei über die Bedieneinheit (6) mehrere standardisierte Programmtypcodes auswählbar sind und der Rundfunkempfänger Mittel zum Zusammenfassen von mehreren ausgewählten Programmtypcodes zu einer Programmtypgruppe enthält, **dadurch gekennzeichnet, dass** der RDS-Rundfunkempfänger Mittel zum Löschen einer Zuordnung eines ausgewählten Programmtypcodes zu einer Programmtypgruppe enthält und die Programmtypgruppe auf der optischen Ausgabeeinheit (5) darstellbar und über die Bedieneinheit (6) auswählbar ist.

2. RDS-Rundfunkempfänger nach einem der vorhergehenden Ansprüche, **dadurch gekennzeichnet, dass** die Programmtypgruppe in einem nicht-flüchtigen Speicherelement (10) abspeicherbar ist.

3. **RDS-RundfunkempfängernachAnspruch2,dadurchgekennzeichnet, dass** mehrere Programmtypgruppen abspeicherbar sind.

4. RDS-Rundfunkempfänger nach einem der vorhergehenden Ansprüche, **dadurch gekennzeichnet, dass** der Programmtypgruppe über die Bedieneinheit (6) eine Kennzeichnung zuweisbar ist.

5. RDS-Rundfunkempfänger nach Anspruch 4, **dadurch gekennzeichnet, dass** die Kennzeichnung ein frei wählbarer Name ist.

6. RDS-Rundfunkempfänger nach einem der vorhergehenden Ansprüche, **dadurch gekennzeichnet, dass** die Bedieneinheit (6) einen Dreh-/Drücksteller zur Eingabe der Kennzeichnung der Programmtypgruppe enthält.

7. RDS-Rundfunkempfänger nach Anspruch 6, **dadurch gekennzeichnet, dass** durch Drehen des Dreh-/Drückstellers ein Cursor über eine auf der optischen Ausgabeeinheit (5) angezeigte Buchstabenabfolge bewegbar und durch Drücken des Dreh-/Drückstellers ein angewählter Buchstabe zur Erzeugung des Namens für die Programmtypgruppe auswählbar ist.

8. RDS-Rundfunkempfänger nach einem der vorhergehenden Ansprüche, **dadurch gekennzeichnet, dass** mindestens zwei standardisierte Programmtypcodes auf der optischen Ausgabeeinheit (5) anzeigbar sind.

9. RDS-Rundfunkempfänger nach einem der vorhergehenden Ansprüche, **dadurch gekennzeichnet, dass** die Bedieneinheit (6) Spracheingabemittel aufweist.

10. RDS-Rundfunkempfänger nach einem der vorhergehenden Ansprüche, **dadurch gekennzeichnet, dass** die optische Ausgabeeinheit (5) als berührungsempfindliche Anzeigeeinheit ausgebildet ist, in die die Bedieneinheit (6) zumindest teilweise integriert ist.

11. Verfahren zur Festlegung eines Rundfunksenders für Audiowiedergabe anhand eines RDS-Programmtypcodes mittels eines RDS-Rundfunkempfängers, wobei mehrere standardisierte Programmtypcodes durch Auswahl aus mehreren, gleichzeitig auf einer optischen Ausgabeeinheit angezeigten Programmtypcodes zu einer Programmtypgruppe zusammengefasst werden und ein Rundfunksender ausgewählt wird, dessen RDS-Programmtypcode in der Programmtypgruppe enthalten ist.

12. Verfahren nach Anspruch 9, **dadurch gekennzeichnet, dass** die Programmtypgruppe in einem nicht-flüchtigen Speicherelement (10) abgespeichert wird.

## Claims

1. RDS broadcast radio receiver having an operator control unit (6) and a visual output unit (5), which are connected to a control unit (4), and also having means for decoding RDS data (RDS decoder 3) which contain a standardized program type code and are supplied to the control unit (4), the operator control unit (6) being able to be used to select a plurality of standardized program type codes, and the broadcast radio receiver containing means for combining a plurality of selected program type codes to form a programme type group, **characterized in that** the RDS broadcast radio receiver contains means for erasing an association between a selected program type code and a programme type group and the programme type group can be shown on the visual output unit (5) and can be selected using the operator control unit (6).

2. RDS broadcast radio receiver according to one of the preceding claims, **characterized in that** the programme type group can be stored in a non-volatile memory element (10).

3. RDS broadcast radio receiver according to Claim 2, **characterized in that** a plurality of programme type groups can be stored.

4. RDS broadcast radio receiver according to one of the preceding claims, **characterized in that** the programme type group can be assigned an identifier using the operator control unit (6).

5. RDS broadcast radio receiver according to Claim 4, **characterized in that** the identifier is a freely selectable name.

6. RDS broadcast radio receiver according to one of the preceding claims, **characterized in that** the operator control unit (6) contains a rotary/push controller for inputting the programme type group's identifier.

7. RDS broadcast radio receiver according to Claim 6, **characterized in that** by rotating the rotary/push controller it is possible to move a cursor through a letter sequence displayed on the visual output unit (5), and by pushing the rotary/push controller it is possible to select a pre-selected letter for producing the name for the programme type group.

8. RDS broadcast radio receiver according to one of the preceding claims, **characterized in that** at least two standardized program type codes can be displayed on the visual output unit (5).

9. RDS broadcast radio receiver according to one of the preceding claims, **characterized in that** the operator control unit (6) has voice input means.

10. RDS broadcast radio receiver according to one of the preceding claims, **characterized in that** the visual output unit (5) is in the form of a touch-sensitive display unit which at least partially incorporates the operator control unit (6).

11. Method for stipulating a broadcast radio station for audio reproduction using an RDS program type code by means of an RDS broadcast radio receiver, where a plurality of standardized program type codes are combined to form a programme type group by means of selection from a plurality of program type codes displayed simultaneously on a visual output unit, and a broadcast radio station is selected whose RDS program type code is contained in a programme type group.

12. Method according to Claim 9, **characterized in that** the programme type group is stored in a non-volatile memory element (10).

## Revendications

1. Récepteur de radiodiffusion à système de radioguidage ou RDS (pour "Radio Data System", en anglais), comportant une unité de commande (6) et une unité optique d'édition (5), lesquelles sont reliées à une unité de contrôle (4), ainsi que des moyens (décodeur RDS 3) permettant de décoder des données RDS de radioguidage, qui comprennent un code normalisé correspondant à un type de programmes et qui sont transmises à l'unité de contrôle (4), où plusieurs codes normalisés de types de programmes peuvent être sélectionnés par l'intermédiaire de l'unité de commande (6) et où le récepteur de radiodiffusion renferme des moyens permettant de regrouper plusieurs codes de types de programmes sélectionnés pour former un groupe de types de programmes, **caractérisé par le fait que** le récepteur de radiodiffusion à système de radioguidage ou RDS renferme des moyens permettant d'effacer l'affectation d'un code de types de programmes sélectionné à un groupe de types de programmes et que le groupe de types de programmes peut être représenté sur l'unité optique d'édition (5) et peut être sélectionné par l'intermédiaire de l'unité de commande (6).

2. Récepteur de radiodiffusion à système de radioguidage ou RDS selon l'une des revendications précédentes, **caractérisé par** l**e fait que** le groupe de types de programmes peut être stocké dans un élément de mémoire non volatile (10).

3. Récepteur de radiodiffusion à système de radioguidage ou RDS selon la revendication 2, **caractérisé par le fait que** plusieurs groupes de types de programmes peuvent être mémorisés.

4. Récepteur de radiodiffusion à système de radioguidage ou RDS selon l'une des revendications précédentes, **caractérisé par le fait qu**'une identification peut être affectée au groupe de types de programmes par l'intermédiaire de l'unité de commande (6).

5. Récepteur de radiodiffusion à système de radioguidage ou RDS selon la revendication 4, **caractérisé par le fait que** l'identification est un nom pouvant être choisi librement.

6. Récepteur de radiodiffusion à système de radioguidage ou RDS selon l'une des revendications précédentes, **caractérisé par le fait que** l'unité de commande (6) renferme un bouton rotatif à pression permettant de saisir l'identification du groupe de types de programmes.

7. Récepteur de radiodiffusion à système de radioguidage ou RDS selon la revendication 6, **caractérisé par le fait qu**'on peut déplacer un curseur sur une liste de lettres affichée sur l'unité optique d'édition (5) en faisant tourner le bouton rotatif à pression et qu'on peut sélectionner une lettre marquée pour produire le nom du groupe de types de programmes en appuyant sur le bouton rotatif à pression.

8. Récepteur de radiodiffusion à système de radioguidage ou RDS selon l'une des revendications précédentes, **caractérisé par le fait qu**'il est possible d'afficher sur l'unité optique d'édition (5) au moins deux codes normalisés de types de programmes.

9. Récepteur de radiodiffusion à système de radioguidage ou RDS selon l'une des revendications précédentes, **caractérisé par le fait que** l'unité de commande (6) comporte des moyens de saisie vocale.

10. Récepteur de radiodiffusion à système de radioguidage ou RDS selon l'une des revendications précédentes, **caractérisé par le fait que** l'unité optique d'édition (5) est conçue sous la forme d'une unité d'affichage tactile dans laquelle l'unité de commande (6) est, au moins partiellement, intégrée.

11. Procédé permettant de définir, à l'aide d'un code RDS de type de programmes, un émetteur de radiodiffusion pour la reproduction sonore au moyen d'un récepteur de radiodiffusion à système de radioguidage ou RDS, où plusieurs codes normalisés de types de programmes peuvent être regroupés par sélection parmi plusieurs types de programmes affichés simultanément sur une unité optique d'édition pour former un groupe de types de programmes et où est sélectionné un émetteur de radiodiffusion dont le code RDS de type de programme fait partie du groupe de types de programmes.

12. Procédé selon la revendication 9, **caractérisé par le fait que** le groupe de types de programmes est stocké dans un élément de mémoire non volatile (10).
